# EUROPEAN PATENT APPLICATION

(11) **EP 4 020 506 A1**
(43) Date of publication of application: **29.06.2022**
(21) Application number: 20855143.2
(22) Date of filing: 30.07.2020
(51) Int. Cl.: H01F 1/117, H05K 9/00, B32B 7/025

(54) **RADIO WAVE ABSORBER FILM AND METHOD FOR PRODUCING SAME**

(30) Priority: 19.08.2019 JP 2019150011
(71) Applicant: The University of Tokyo, Bunkyo-ku Tokyo 113-8654 (JP); TOKYO OHKA KOGYO CO., LTD., Kawasaki-shi, Kanagawa 211 0012 (JP)
(72) Inventor: OHKOSHI, Shin-ichi, Tokyo 113-8654 (JP); NAMAI, Asuka, Tokyo 113-8654 (JP); YOSHIKIYO, Marie, Tokyo 113-8654 (JP); HARA, Masayuki, Kawasaki-shi, Kanagawa 211-0012 (JP); ASAI, Takahiro, Kawasaki-shi, Kanagawa 211-0012 (JP)
(74) Representative: Plasseraud IP
(86) International application number: PCT/JP2020/029362
(87) International publication number: WO 2021/033517

(57) **Abstract**

The present invention provides: a radio wave absorber film which is thin and exhibits excellent radio wave absorption performance; and a method for producing this radio wave absorber film. According to the present invention, a radio wave absorber film formed on a base material layer contains a magnetic body and a binder resin in a radio wave absorption layer; and an aromatic ester-urethane copolymer is used as the binder resin. The glass transition temperature of the binder resin is preferably 100°C or less, and more preferably 0°C or less. The magnetic body is preferably at least one substance that is selected from the group consisting of ε-iron oxide, a barium ferrite magnetic body and a strontium ferrite magnetic body.

## Description

### TECHNICAL FIELD

The present invention relates to a radio wave absorber film having excellent radio wave absorbing performance and a method for producing the radio wave absorber film.

### BACKGROUND ART

Radio waves in a high-frequency band are increasingly being used in various information communication systems such as cellular telephones, wireless local area networks (LANs), electronic throttle control (ETC) systems, intelligent transport systems, driving support road systems, satellite broadcasting, and the like. However, the increasing use of the radio waves in a high-frequency band involves a risk of failure and malfunction of electronic devices due to interference between electronic parts. In order to address such a problem, a method of absorbing unnecessary radio waves by a radio wave absorber has been employed.

Accordingly, in a radar or the like using the radio waves in a high-frequency band, radio wave absorbers have been used in order to reduce the influence of unnecessary radio waves that should not be received. In order to meet such a demand, various radio wave absorbers capable of satisfactorily absorbing the radio waves in a high-frequency band have been proposed. Well-known specific examples thereof include radio wave absorbing sheets including a carbon nano-coil and a resin (e.g., Patent Document 1).

Among applications of the radio waves in a high-frequency band, research on operation support systems for automobiles has progressed. In such operation support systems for automobiles, radio waves in a 76-GHz band have been utilized in automotive radars for detecting an inter-vehicular distance and the like. In various applications not just limited to the operation support systems, the radio waves in a high-frequency band, for example, in 100 GHz or higher are expected to be increasingly used. Therefore, there is a need for radio wave absorbers capable of satisfactorily absorbing radio waves in the 76-GHz band or higher frequency band.

In order to meet such a demand, for example, a radio wave absorber that includes a radio wave absorbing layer including a magnetic crystal composed of ε-Fe2O3-based iron oxide has been proposed as a radio wave absorber capable of satisfactorily absorbing radio waves over a wide range in a high-frequency band (e.g., Patent Document 2 and Non-Patent Documents 1 to 3).

Patent Document 1: Japanese Unexamined Patent Application, Publication No. 2009-060060
Patent Document 2: Japanese Unexamined Patent Application, Publication No. 2008-277726

Non-Patent Document 1:
   A.Namai,S.Sakurai,M.Nakajima,T.Suemoto,K.Matsumoto,M.Goto,S.Sa saki, and S.Ohkoshi, J.Am.Chem.Soc.,131,1170-1173(2009).
Non-Patent Document 2:
   A.Namai,M.Yoshikiyo,K.Yamada,S.Sakurai,T.Goto,T.Yoshida,T.Miya zaki,M.Nakajima,T.Suemoto,H.Tokoro, and S.Ohkoshi,Nature Communications,3,1035/1-6(2012).
Non-Patent Document 3:
   S.Ohkoshi,S.Kuroki,S.Sakurai,K.Matsumoto,K.Sato, and
   S.Sasaki,Angew.Chem.Int.Ed.,46,8392-8395(2007).

### DISCLOSURE OF THE INVENTION

### Problems to be Solved by the Invention

However, there is a keen demand for a radio wave absorbing sheet as described in Patent Document 1 to achieve both thinner thickness and more excellent radio wave absorbing performance.

The present invention has been made in view of the above-described problem, and an object thereof is to provide a radio wave absorber film being thin and having excellent radio wave absorbing performance; and a method for producing the radio wave absorber film.

### Means for Solving the Problems

The present inventors have completed the present invention by finding that the above-described problem can be solved by including a magnetic substance and a binder resin in a radio wave absorbing layer and using an aromatic ester-urethane copolymer as the binder resin in a radio wave absorber film formed on a substrate layer.

A first aspect of the present invention relates to a radio wave absorber film including
a substrate layer; and
a radio wave absorbing layer formed on the substrate layer,
the radio wave absorbing layer including a magnetic substance and a binder resin; and
the binder resin including an aromatic ester-urethane copolymer.

A second aspect of the present invention relates to a method for producing a radio wave absorber film including: forming a radio wave absorbing layer by coating a substrate layer with paste including a magnetic substance and a binder resin to thereby form a coating film and then drying the coating film,
the binder resin including an aromatic ester-urethane copolymer.

### Effects of the Invention

The present invention can provide a radio wave absorber film being thin and having excellent radio wave absorbing performance; and a method for producing the radio wave absorber film.

### BRIEF DESCRIPTION OF THE DRAWINGS

FIG. 1 is a graph illustrating reflection loss of the radio wave absorber film of Example 1;
FIG. 2 is a graph illustrating reflection loss of the radio wave absorber film of Example 2;
FIG. 3 is a graph illustrating reflection loss of the radio wave absorber film of Example 3;
FIG. 4 is a graph illustrating reflection loss of the radio wave absorber film of Example 4; and
FIG. 5 is a graph illustrating reflection loss of the radio wave absorber film of Comparative Example 1.

### PREFERRED MODE FOR CARRYING OUT THE INVENTION

Although embodiments of the present invention will be described hereafter in detail, the present invention is not limited to the embodiments below in any way and can be implemented with modifications as appropriate within the scope of the object of the present invention. Furthermore, as used herein, "A to B" denotes A or more and B or less, unless otherwise noted.

### <<Radio wave absorber film>>

A radio wave absorber film includes a radio wave absorbing layer formed on a substrate layer. The radio wave absorbing layer includes a magnetic substance and a binder resin. The binder resin includes an aromatic ester-urethane copolymer. The radio wave absorber film having an excellent radio wave absorbing property even in a form of a thin film can be produced by including the magnetic substance and the aromatic ester-urethane copolymer serving as the binder resin in the radio wave absorbing layer.

For the radio wave absorber film, a frequency band is preferably 30 gigahertz (GHz) or more, preferably 30 GHz or more and 300 GHz or less, and more preferably 40 GHz or more and 200 GHz or less, from the viewpoint of the possibility of more secure absorption of radio waves at high frequencies in a millimeter-wave band or higher. Preferably, there is a peak at which an absolute value of reflection loss is 30 dB or more as measured from a side of a surface on which the radio wave absorbing layer is formed. The value of transmission loss is a value as measured under the measurement conditions in Examples described below unless otherwise noted.

The radio wave absorber film may have a curved surface or be only composed of a planar surface, and is preferably a flat plate shape. A thickness of the radio wave absorber film is preferably 1000 µm or less, more preferably 900 µm or less, further preferably 450 µm or less, and particularly preferably 200 µm or less from the viewpoint of thinning or downsizing of the film without impairing the effect of the present invention. The thickness of the radio wave absorber film may be uniform or ununiform.

### <Radio wave absorbing layer>

As mentioned above, the radio wave absorbing layer includes the binder resin along with the magnetic substance. The binder resin includes the aromatic ester-urethane copolymer.

A film thickness of the radio wave absorbing layer is not particularly limited without interfering with the objective of the present invention. The film thickness of the radio wave absorbing layer is preferably 100 µm or less and more preferably 50 µm or less from the viewpoint of a balance of thinning and radio wave absorbing performance of the radio wave absorber film. The lower limit of the thickness of the radio wave absorbing layer is not particularly limited without impairing the effect of the present invention, but is, for example, 1 µm or more, 10 µm or more, or the like. The thickness of the radio wave absorbing layer may be uniform or ununiform.

Essential or optional components of the radio wave absorbing layer will be described.

### [Binder resin]

The radio wave absorbing layer includes the binder resin along with the magnetic substance. The binder resin includes the aromatic ester-urethane copolymer. It is possible to produce the radio wave absorber film exhibiting an excellent radio wave absorbing property even though it is thin while allowing the magnetic substance to be well dispersed in the binder resin by using the aromatic ester-urethane copolymer as the binder resin.

Furthermore, when the aromatic ester-urethane copolymer is used as the binder resin, crack resistance upon bending or cutting and a low warping property can be imparted to the radio wave absorbing layer. The binder resin has preferably a glass transition temperature of 100°C or less and more preferably 0°C or less from the viewpoint of good crack resistance and low warping property of the radio wave absorbing layer. Therefore, the aromatic ester-urethane copolymer also has preferably the glass transition temperature of 100°C or less and more preferably 0°C or less.

The aromatic ester-urethane copolymer is a copolymer having an ester bond (-CO-O-) and a urethane bond (-NH-CO-O-) and including an aromatic group in a main chain backbone thereof. The aromatic group in the main chain backbone may be an aromatic hydrocarbon group or a heterocyclic aromatic group, but is preferably the aromatic hydrocarbon group. The aromatic ester-urethane copolymer may be a random copolymer in which an ester bond and a urethane bond are randomly introduced into a molecular chain or a block copolymer composed of one or more ester blocks and one or more urethane blocks.

A method for producing the aromatic ester-urethane copolymer is not particularly limited. The aromatic ester-urethane copolymer can be typically produced by polymerizing one or more monomers selected from the group consisting of a diol component (a1), a dicarboxylic acid (a2), a hydroxycarboxylic acid component (a3), and a diisocyanate component (a4) in a one-step or multistep process.

The dicarboxylic acid component (a2) and the hydroxycarboxylic acid component (a3) may be used as an ester derivative such as methyl ester or ethyl ester; or an ester- or urethane-forming derivative, for example, halide carboxylate such as chloride carboxylate.

The above-mentioned monomers to be used for producing the aromatic ester-urethane copolymer are preferably a compound in which two functional groups selected from the group consisting of a hydroxyl group, a carboxyl group, and an isocyanate group are bound to an unbranched divalent hydrocarbon group. Examples of the unbranched divalent hydrocarbon group include an alkylene group, an alkenylene group, an alkynylene group, an arylene group, or a combination thereof. The alkylene group, the alkenylene group, and the alkynylene group are preferably linear.

When the unbranched divalent hydrocarbon group is the alkylene group, the alkenylene group, or the alkynylene group, these groups have preferably 1 or more and 8 or less carbon atoms, more preferably 2 or more and 6 or less carbon atoms, and further preferably 2 or more and 4 or less carbon atoms.

When the unbranched divalent hydrocarbon group is the alkylene group, the arylene group is preferably a phenylene group and a naphthylene group, more preferably a phenylene group, and further preferably a p-phenylene group.

Among the above-mentioned unbranched divalent hydrocarbon groups, the alkylene group, the arylene group, and a combination of the alkylene group and the arylene group are preferred.

Suitable specific examples of the diol component (a1) include ethylene glycol, 1,3-propane diol, 1,4-butane diol, neopentyl glycol, 1,6-hexane diol, 1,4-cyclohexane dimethanol, and 1,5-pentane diol. Suitable specific examples of the dicarboxylic acid (a2) include terephthalic acid, isophthalic acid, 2,6-naphthalene dicarboxylic acid, 2,7-naphthalene dicarboxylic acid, 1,4-naphthalene dicarboxylic acid, 1,4-cyclohexane dicarboxylic acid, succinic acid, glutaric acid, adipic acid, oxalic acid, and malonic acid. Suitable specific examples of the hydroxycarboxylic acid component (a3) include 4-hydroxybenzoic acid, 3-hydroxybenzoic acid, 6-hydroxynaphthalene-2-carboxylic acid, glycolic acid, lactic acid, and γ-hydroxybutyric acid. Suitable specific examples of the diisocyanate component (a4) include ethylene diisocyanate, trimethylene diisocyanate, tetramethylene diisocyanate, hexamethylene diisocyanate, isophorone diisocyanate, m-xylene diisocyanate, p-phenylene diisocyanate, tolylene diisocyanate, 4,4'-diphenylmethane diisocyanate, and 1,5-naphthalene diisocyanate.

The aromatic ester-urethane copolymer has preferably a weight average molecular weight (Mw) of 5000 or more and 500000 or less and more preferably 10000 or more and 200000 or less. In the present specification, the weight average molecular weight (Mw) refers to a weight average molecular weight in terms of polystyrene as measured by gel permeation chromatography (GPC).

Examples of commercially available products of the aromatic ester-urethane copolymer include VYLON series (product name) (manufactured by TOYOBO CO., LTD.). More specifically, VYLON UR-1400, VYLON UR-1410, VYLON UR-1700, VYLON UR-2300, VYLON UR-3200, VYLON UR-3210, VYLON UR-3500, VYLON UR-6100, VYLON UR-8300, and VYLON UR-8700 can be preferably used.

The binder resin may include other resins other than the aromatic ester-urethane copolymer without interfering with the objective of the present invention. A type of the other resins is not particularly limited unless the objective of the present invention is interfered with. The other resins may be an elastic material such as an elastomer or rubber. Furthermore, the other resins may be a thermoplastic resin or a curable resin. When the other resins are the curable resin, the curable resin may be a photocurable resin or a thermosetting resin.

Suitable examples of the other resins being the thermoplastic resin include a polyacetal resin, a polyamide resin, a polycarbonate resin, a polyester resin (polybutylene terephthalate, polyethylene terephthalate, polyarylate, and the like), an FR-AS resin, an FR-ABS resin, an AS resin, an ABS resin, a polyphenylene oxide resin, a polyphenylene sulfide resin, a polysulfone resin, a polyethersulfone resin, a polyether ether ketone resin, a fluorine-based resin, a polyimide resin, a polyamide-imide resin, a polyamide bismaleimide resin, a polyetherimide resin, a polybenzoxazole resin, a polybenzothiazole resin, a polybenzimidazole resin, a BT resin, polymethylpentene, ultra-high molecular weight polyethylene, FR-polypropylene, a cellulose resin (e.g., methylcellulose, ethylcellulose), a (meta)acrylic resin (polymethyl methacrylate and the like), polystyrene, and the like.

Suitable examples of the other resins being the thermosetting resin include a phenolic resin, a melamine resin, an epoxy resin, an alkyd resin, and the like. As the photocurable resin, a resin obtained by photocuring of various vinyl monomers or various monomers having an unsaturated bond such as (meth)acrylic ester can be used.

Suitable examples of the other resins being the elastic material include an olefin-based elastomer, a styrene-based elastomer, a polyamide-based elastomer, a polyester-based elastomer, a polyurethane-based elastomer, and the like.

A mass rate of the other resins relative to a total mass of the binder resin is not particularly limited without interfering with the objective of the present invention. The mass rate of the other resins relative to a total mass of the binder resin is, for example, preferably 20% by mass or less, more preferably 10% by mass or less, further preferably 5% by mass or less, yet more preferably 1% by mass or less, and most preferably 0% by mass because the radio wave absorber film having a desired property is easily produced.

A content of the binder resin in the radio wave absorbing layer is not particularly limited without interfering with the objective of the present invention. The content of the binder resin is preferably 5% by mass or more and 30% by mass or less and more preferably 10% by mass or more and 25% by mass or less relative to a solid content of the radio wave absorbing layer.

### [Magnetic substance]

A type of the magnetic substance is not particularly limited as long as the radio wave absorber film exhibits a desired radio wave absorbing property. The above-mentioned magnetic substance is preferably a magnetic substance magnetically resonating in a frequency band of 30 GHz or more and more preferably a magnetic substance magnetically resonating in a frequency band of 30 GHz or more and 300 GHz or less from the viewpoint of the possibility of absorption of radio waves at high frequencies in a millimeter-wave band or higher.

An example of the above-mentioned magnetic resonance includes magnetic resonance based on precession upon spin motion of electrons in atoms in a frequency band of a millimeter-wave band or higher. A preferred example thereof includes natural magnetic resonance by a gyromagnetic effect based on precession in a frequency band of a millimeter-wave band or higher.

The above-mentioned magnetic substance is not particularly limited as long as the magnetic substance can absorb radio waves at high frequencies in a millimeter-wave band or higher. Preferred examples of the magnetic substance include magnetic substances including at least one selected from the group consisting of epsilon-type iron oxide, barium ferrite magnetic substance, and strontium ferrite magnetic substance. Hereinafter, the epsilon-type iron oxide will be described.

### (Epsilon-Type Iron Oxide)

The epsilon-type iron oxide is preferably at least one selected from the group consisting of an ε-Fe₂O₃ crystal; and a crystal of which crystalline structure and space group are the same as those of the ε-Fe₂O₃ crystal, in which a part of Fe sites in the ε-Fe₂O₃ crystal is substituted by an element M other than Fe, and which is represented by a formula ε-MₓFe₂₋ₓO₃ wherein x is 0 or more and 2 or less and preferably 0 or more and less than 2. Since crystals of the epsilon-type iron oxide are magnetic crystals, such crystals may also be referred to as "magnetic crystals" herein.

Any ε-Fe₂O₃ crystals can be used. The crystal of which crystalline structure and space group are the same as those of the ε-Fe₂O₃ crystal, in which a part of Fe sites in the ε-Fe₂O₃ crystal is substituted by an element M other than Fe, and which is represented by a formula ε-MₓFe₂₋ₓO₃ wherein x is 0 or more and 2 or less and preferably 0 or more and less than 2, is described later. It should be noted that ε-MₓFe₂₋ₓO₃, in which a part of Fe sites in the ε-Fe₂O₃ crystal is substituted by a substitution element M, is also referred to as "M-substituted ε-Fe₂O₃" herein.

A particle size of a particle having the ε-Fe₂O₃ crystal and/or the M-substituted ε-Fe₂O₃ crystal in a magnetic phase is not particularly limited without interfering with the objective of the present invention. For example, an average particle size, as measured from a TEM (transmission electron microscope) photograph, of a particle having a magnetic crystal of epsilon-type iron oxide in a magnetic phase, which is manufactured by way of a method to be described later, is within a range of 5 nm or more and 200 nm or less. Furthermore, a variation coefficient (standard deviation of particle size/average particle size) of the particles each having a magnetic crystal of epsilon-type iron oxide in a magnetic phase, which is manufactured by way of the method to be described later, is within a range of less than 80%, which means that the particles are relatively fine and uniform in particle size.

The preferable radio wave absorbing layer use powder of such magnetic particles of epsilon-type iron oxide (in other words, particles having an ε-Fe₂O₃ crystal and/or an M-substituted ε-Fe₂O₃ crystal in a magnetic phase) as the magnetic substance, the radio wave absorbing material in the radio wave absorbing layer. As used herein, the "magnetic phase" is a part of the powder that carries a magnetic property. "Having an ε-Fe₂O₃ crystal and/or an M-substituted ε-Fe₂O₃ crystal in a magnetic phase" means that the magnetic phase is composed of an ε-Fe₂O₃ crystal and/or an M-substituted ε-Fe₂O₃ crystal, and includes a case in which an impurity magnetic crystal, which is inevitable in manufacturing, is mixed into the magnetic phase.

The magnetic crystal of epsilon-type iron oxide may include an impurity crystal of iron oxide having a space group and an oxidized state different from those of the ε-Fe₂O₃ crystal (specifically, α-Fe₂O₃, γ-Fe₂O₃, FeO, and Fe₃O₄ crystals, as well as such crystals in which a part of Fe is substituted by other elements). In a case in which the magnetic crystal of epsilon-type iron oxide includes the impurity crystal, a main phase is preferably a magnetic crystal of ε-Fe₂O₃ and/or M-substituted ε-Fe₂O₃. In other words, in the magnetic crystal of epsilon-type iron oxide constituting the radio wave absorbing material, a ratio of the magnetic crystal of ε-Fe₂O₃ and/or M-substituted ε-Fe₂O₃ is preferably 50 mol% or more in a molar ratio as a compound.

An abundance ratio of crystals can be obtained by analysis through the Rietveld method based on X-ray diffraction pattern. Non-magnetic compounds generated in a sol-gel process such as silica (SiO₂) may be attached around the magnetic phase.

### (M-substituted ε-Fe₂O₃)

As long as the M-substituted ε-Fe₂O₃ satisfies the conditions that a crystalline structure and a space group are the same as those of the ε-Fe₂O₃ crystal, and that a part of Fe sites in the ε-Fe₂O₃ crystal is substituted by an element M other than Fe, a type of the element M in the M-substituted ε-Fe₂O₃ is not particularly limited. The M-substituted ε-Fe₂O₃ may include a plurality of types of element M other than Fe.

Preferred examples of the element M include In, Ga, Al, Sc, Cr, Sm, Yb, Ce, Ru, Rh, Ti, Co, Ni, Mn, Zn, Zr, and Y. Among these, In, Ga, Al, Ti, Co, and Rh are preferable. In a case in which M is Al, in a composition represented by ε-MₓFe₂₋ₓO₃, x is preferably within a range of, for example, 0 or more and less than 0.8. In a case in which M is Ga, x is preferably within a range of, for example, 0 or more and less than 0.8. In a case in which M is In, x is preferably within a range of, for example, 0 or more and less than 0.3. In a case in which M is Rh, x is preferably within a range of, for example, 0 or more and less than 0.3. In a case in which M is Ti and Co, x is preferably within a range of, for example, 0 or more and less than 1.

The frequency at which a radio wave absorption amount is maximum can be adjusted by adjusting at least one of a type and a substitution amount of the element M in the M-substituted ε-Fe₂O₃.

Such an M-substituted ε-Fe₂O₃ magnetic crystal can be synthesized by, for example, a combined process of a reverse micelle method and the sol-gel method described later, as well as a calcination process. The M-substituted ε-Fe₂O₃ magnetic crystal can also be synthesized by a combined process of a direct synthesis method and the sol-gel method as disclosed in Japanese Unexamined Patent Application Publication No. 2008-174405, as well as a calcination process.

Specifically,
the M-substituted ε-Fe₂O₃ magnetic crystal can be obtained by a combined process of the reverse micelle method and the sol-gel method as well as a calcination process, as disclosed in Jian Jin, Shinichi Ohkoshi and Kazuhito Hashimoto, ADVANCED MATERIALS 2004, 16, No. 1, January 5, pp. 48-51;
Shin-ichi Ohkoshi, Shunsuke Sakurai, Jian Jin, Kazuhito Hashimoto, JOURNAL OF APPLIED PHYSICS, 97, 10K312 (2005); Shunsuke Sakurai, Jian Jin, Kazuhito Hashimoto, and Shinichi Ohkoshi, JOURNAL OF THE PHYSICAL SOCIETY OF JAPAN, Vol. 74, No. 7, July 2005, pp. 1946-1949;
Asuka Namai, Shunsuke Sakurai, Makoto Nakajima, Tohru Suemoto, Kazuyuki Matsumoto, Masahiro Goto, Shinya Sasaki, and Shinichi Ohkoshi, Journal of the American Chemical Society, Vol. 131, pp. 1170-1173, 2009; and the like.

In the reverse micelle method, two types of micellar solutions including a surfactant, i.e., a micellar solution I (raw material micelle) and a micellar solution II (neutralizer micelle) are blended, thereby causing precipitation reaction of iron hydroxide in a micelle. Thereafter, surfaces of iron hydroxide particulates generated in the micelle are subjected to silica coating, by the sol-gel method. The iron hydroxide particulates with a silica coating layer are separated from liquid and then subjected to heat treatment in an atmospheric environment at a predetermined temperature (within a range of 700 to 1300°C).
This heat treatment creates ε-Fe₂O₃ crystal particulates.

More specifically, the M-substituted ε-Fe₂O₃ magnetic crystal is manufactured, for example, as follows.

First, in an aqueous phase of the micellar solution I with an oil phase being n-octane: iron (III) nitrate as an iron source; M nitrate as an M element source for substituting a part of iron (in the case of Al, aluminum (III) nitrate nonahydrate; in the case of Ga, gallium (III) nitrate hydrate; in the case of In, indium (III) nitrate trihydrate); and in the case of Ti and Co, titanium (IV) sulfate hydrate and cobalt (II) nitrate hexahydrate; and a surfactant (e.g., cetyltrimethylammonium bromide) are dissolved.

An appropriate amount of nitrate of an alkali earth metal (Ba, Sr, Ca, etc.) can be dissolved in advance in an aqueous phase of the micellar solution I. The nitrate functions as a shape controlling agent. Under the presence of the alkali earth metal in the solution, rod-shaped particles of the M-substituted ε-Fe₂O₃ magnetic crystal are finally obtained. Without any shape controlling agent, near-spherical particles of the M-substituted ε-Fe₂O₃ magnetic crystal are obtained.

The alkali earth metal added as the shape controlling agent may remain on a surface portion of the M-substituted ε-Fe₂O₃ magnetic crystal being generated. A mass of the alkali earth metal in the M-substituted ε-Fe₂O₃ magnetic crystal is preferably 20% by mass or less and more preferably 10% by mass or less with respect to a total mass of the substitution element M and Fe in the M-substituted ε-Fe2O3 magnetic crystal.

Ammonia aqueous solution is used as an aqueous phase of the micellar solution II with an oil phase being n-octane.

After blending the micellar solution I and the micellar solution II, the sol-gel method is applied. That is, stirring is continued during dropwise addition of silane (e.g., tetraethyl orthosilane) to the micellar solution mixture, thereby causing formation reaction of iron hydroxide or element M-containing iron hydroxide in a micelle. As a result, surfaces of precipitated particulates of iron hydroxide generated in the micelle are coated with silica generated by hydrolysis of the silane.

Thereafter, particle powder obtained by separating from liquid, washing, and then drying the silica-coated M element-containing iron hydroxide particles is fed into a furnace, and subjected to heat treatment (calcination) in the air within a temperature range of 700°C or more and 1300°C or less, preferably 900°C or more and 1200°C or less, and further preferably 950°C or more and 1150°C or less. The heat treatment causes an oxidation reaction in the silica coating, thereby changing particulates of the M element-containing iron hydroxide into particulates of the M-substituted ε-Fe₂O₃.

Upon this oxidation reaction, the silica coating contributes to generation of an M-substituted ε-Fe₂O₃ crystal having the same space group as that of ε-Fe₂O₃, instead of α-Fe₂O₃ or γ-Fe₂O₃ crystal, and has also an effect of preventing sintering of particles. In addition, an appropriate amount of an alkali earth metal promotes growth of the particles in a rod-like shape.

In addition, as described above, the M-substituted ε-Fe₂O₃ magnetic crystal can be synthesized more economically advantageously by the combined process of the direct synthesis method and the sol-gel method as disclosed in Japanese Unexamined Patent Application Publication No. 2008-174405, as well as a calcination process.

In brief, by firstly adding a neutralizer such as an ammonia aqueous solution to an aqueous solvent in which a trivalent iron salt and a salt of the substitution element M (Ga, Al, etc.) are dissolved while stirring, a precursor composed of iron hydroxide (which may have been partially substituted by other elements) is formed.

Thereafter, the sol-gel method is applied thereto, thereby forming a coating layer of silica on surfaces of precursor particles. After being separated from the liquid, the silica-coated particles are subjected to heat treatment (calcination) at a predetermined temperature, thereby obtaining particulates of the M-substituted ε-Fe₂O₃ magnetic crystal.

In the above-described synthesis of the M-substituted ε-Fe₂O₃, an iron oxide crystal (impurity crystal) having a space group and an oxidized state different from those of the ε-Fe₂O₃ crystal may be generated. The most common examples of polymorphism, which has a composition of Fe₂O₃ with different crystal structures, include α-Fe₂O₃ and γ-Fe₂O₃. Other iron oxides include FeO, Fe₃O₄, and the like. Presence of such impurity crystals is not preferable in terms of maximizing the characteristics of the M-substituted ε-Fe₂O₃ crystal, but is acceptable without interfering with the effect of the present invention.

In addition, a coercive force Hc of the M-substituted ε-Fe₂O₃ magnetic crystal varies depending on an amount substituted by the substitution element M. In other words, by adjusting the substitution amount by the substitution element M in the M-substituted ε-Fe₂O₃ magnetic crystal, the coercive force Hc of the M-substituted ε-Fe₂O₃ magnetic crystal can be adjusted. Specifically, for example, in a case in which Al, Ga, or the like is used as the substitution element M, a greater substitution amount results in a lower coercive force Hc of the M-substituted ε-Fe₂O₃ magnetic crystal. In contrast, in a case in which Rh or the like is used as the substitution element M, a greater substitution amount results in a greater coercive force Hc of the M-substituted ε-Fe₂O₃ magnetic crystal. Ga, Al, In, Ti, Co, and Rh are preferred as the substitution element M from the viewpoint of easy adjustment of the coercive force Hc of the M-substituted ε-Fe₂O₃ magnetic crystal in accordance with the substitution amount by the substitution element M.

Along with the lowering of the coercive force Hc, a peak frequency, at which a radio wave absorption amount by the epsilon-type iron oxide is maximum, moves toward a lower frequency side or a higher frequency side. That is, a peak frequency of the radio wave absorption amount can be controlled by the substitution amount by the substitution element M.

In the case of commonly used radio wave absorbers, the absorption amount becomes almost zero if an incident angle or a frequency of a radio wave is out of a designed value. In contrast, in the case of using the epsilon-type iron oxide, even if those values are slightly out of the designed values, radio wave absorption is exhibited over a broad range of frequencies and radio wave incident angles. Given this, a radio wave absorbing layer that can absorb radio waves over a broad frequency band can be provided.

A particle size of the epsilon-type iron oxide can be controlled by, for example, adjusting the temperature of the heat treatment (calcination) in the above-described process. According to the combined process of the reverse micelle method and the sol-gel method, or the combined process of the direct synthesis method and the sol-gel method as disclosed in Japanese Unexamined Patent Application Publication No. 2008-174405, particles of epsilon-type iron oxide can be synthesized, which has a particle size within a range of 5 nm or more and 200 nm or less as an average particle size as measured from a TEM (transmission electron microscope) photograph. The average particle size of the epsilon-type iron oxide is more preferably 10 nm or more and more preferably 20 nm or more. It should be noted that, when calculating the average particle size as a number average particle size, if the particles of epsilon-type iron oxide are rod-shaped, a diameter in a longitudinal direction of the particle observed in a TEM photograph is considered to be a diameter of the particle. The number of particles to be counted for calculating the average particle size is not particularly limited as long as it is large enough to calculate an average value thereof; however, is preferably 300 or more.

In addition, the silica coated on a surface of the iron hydroxide particulate in the sol-gel method may remain on a surface of the M-substituted ε-Fe₂O₃ magnetic crystal after the heat treatment (calcination). Presence of a non-magnetic compound such as silica on the surface of the crystal is preferable for improving handleability, durability, weather resistance, and the like of the magnetic crystal. Preferable examples of the non-magnetic compound other than silica include heat resistant compounds such as alumina and zirconia.

However, an excessive amount of the non-magnetic compound attached may cause heavy aggregation of particles and is therefore not preferable. In a case in which the non-magnetic compound is silica, a mass of Si in the M-substituted ε-Fe₂O₃ magnetic crystal is preferably 100% by mass or less with respect to a total mass of the substitution element M and Fe in the M-substituted ε-Fe₂O₃ magnetic crystal. A part or a large part of silica attached to the M-substituted ε-Fe₂O₃ magnetic crystal can be removed by a method of immersion in an alkaline solution. The amount of silica to be attached can thus be adjusted to any desired amount.

A content of the magnetic substance in the radio wave absorbing layer is not particularly limited without interfering with the objective of the present invention. The content of the magnetic substance is preferably 30% by mass or more, more preferably 40% by mass or more, particularly preferably 60% by mass or more, and most preferably 60% by mass or more and 91% by mass or less with respect to a solid content mass of the radio wave absorbing layer.

### (Relative Permittivity Adjustment Method)

Relative permittivity of the radio wave absorbing layer is not particularly limited, but is preferably 6.5 or more and 65 or less, more preferably 10 or more and 50 or less, and further preferably 15 or more and 30 or less. A method of adjusting the relative permittivity of the radio wave absorbing layer is not particularly limited. Examples of a method of adjusting the relative permittivity of each of the radio wave absorbing layer include a method of adding dielectric powder to the radio wave absorbing layer while adjusting a content of the dielectric powder.

Preferred examples of the dielectric include barium titanate, strontium titanate, calcium titanate, magnesium titanate, bismuth titanate, zirconium titanate, zinc titanate, and titanium dioxide. The radio wave absorbing layer can include a combination of multiple types of dielectric powder.

A particle size of the dielectric powder used for adjusting the relative permittivity of the radio wave absorbing layer is not particularly limited without interfering with the objective of the present invention. An average particle size of the dielectric powder is preferably 1 nm or more and 100 nm or less, and more preferably 5 nm or more and 50 nm or less. The average particle size of the dielectric powder is a number average particle size of primary particles of the dielectric powder observed by an electron microscope.

In a case of adjusting the relative permittivity of the radio wave absorbing layer using the dielectric powder, an amount of the dielectric powder to be used is not particularly limited as long as the relative permittivity of the radio wave absorbing layer is within a predetermined range. An amount of the dielectric powder to be used is preferably 0% by mass or more and 20% by mass or less and more preferably 5% by mass or more and 10% by mass or less with respect to a solid content mass of each of the radio wave absorbing layer.

Alternatively, by adding a carbon nanotube to the radio wave absorbing layer, the relative permittivity can be adjusted. The carbon nanotube may be used together with the above-described dielectric powder.

An amount of the carbon nanotube to be incorporated in the radio wave absorbing layer is not particularly limited as long as the relative permittivity of the radio wave absorbing layer is within the above-mentioned predetermined range. However, since the carbon nanotube is also a conductive material, an excessive amount of the carbon nanotube may deteriorate a radio wave absorbing property provided by the radio wave absorbing layer. An amount of the carbon nanotube to be used is preferably 0% by mass or more and 20% by mass or less and more preferably 1% by mass or more and 10% by mass or less with respect to a solid content mass of the radio wave absorbing layer.

### (Relative Magnetic Permeability Adjustment Method)

Relative magnetic permeability of the radio wave absorbing layer is not particularly limited, but is preferably 1.0 or more and 1.5 or less. A method of adjusting the relative magnetic permeability of the radio wave absorbing layer is not particularly limited. Examples of a method of adjusting the relative magnetic permeability of each of the radio wave absorbing layer include a method of adjusting the substitution amount by the substitution element M in the epsilon-type iron oxide as described above, a method of adjusting a content of the magnetic substance in the radio wave absorbing layer, and the like.

### (Dispersant)

In order to favorably disperse the above-mentioned magnetic substance and a substance to be added for adjusting the relative permittivity and the relative magnetic permeability in the radio wave absorbing layer, the radio wave absorbing layer can include a dispersant. The dispersant can be blended uniformly along with the above-mentioned magnetic substance, the polymer, and the like. The dispersant may be incorporated in the binder resin. Furthermore, the above-mentioned magnetic substance and the substance to be added for adjusting the relative permittivity and the relative magnetic permeability that are treated with the dispersant in advance can be incorporated into a material constituting the radio wave absorbing layer.

A type of the dispersant is not particularly limited without interfering with the objective of the present invention. The dispersant can be selected from various dispersants conventionally used for dispersion of various inorganic particulates and organic particulates.

Preferred examples of the dispersant include a silane coupling agent (e.g., phenyltrimethoxysilane), a titanate coupling agent, a zirconate coupling agent, an aluminate coupling agent, and the like.

A content of the dispersant is not particularly limited without interfering with the objective of the present invention. The content of the dispersant is preferably 0.1% by mass or more and 30% by mass or less, more preferably 1% by mass or more and 15% by mass or less, and particularly preferably 1% by mass or more and 10% by mass or less with respect to a solid content mass of the radio wave absorbing layer.

### (Other Components)

The radio wave absorbing layer may include various additives other than the above-mentioned components without interfering with the objective of the present invention. Examples of the additives that may be included in the radio wave absorbing layer include a coloring agent, an antioxidant, a UV absorber, a fire retardant, a fire retardant aid, a plasticizer, a surfactant, and the like. These additives are used without interfering with the objective of the present invention, taking into consideration conventionally used amounts thereof.

### <Radio wave Absorbing Layer Forming Paste>

A method for producing the radio wave absorbing layer is preferably a method of using a radio wave absorbing layer forming paste from the viewpoints of the possibility of forming the radio wave absorbing layer with high efficiency without limitation of thickness and the possibility of forming the radio wave absorbing layer directly on the substrate layer. The radio wave absorbing layer forming paste preferably includes the above-mentioned binder resin and the above-mentioned magnetic substance. The radio wave absorbing layer forming paste may include the substances added for adjusting relative permittivity and relative magnetic permeability, and the other components, and the like, as described for the radio wave absorbing layer. When the binder resin includes a curing resin, the radio wave absorbing layer forming paste includes a compound that is a precursor of the curing resin. In this case, the radio wave absorbing layer forming paste includes a curing agent, a curing promoter, a polymerization initiator, and the like as necessary.

Furthermore, when the radio wave absorbing layer forming paste includes a photopolymerizable or thermopolymerizable compound, the radio wave absorbing layer can be formed by exposing or heating a film on which the paste is applied.

The radio wave absorbing layer forming paste preferably further includes a dispersion medium. As the dispersion medium, water, an organic solvent, and an aqueous solution of an organic solvent can be used. As the dispersion medium, the organic solvent is preferable, since the organic solvent can easily dissolve organic components and has low latent heat of vaporization allowing easy removal by drying.

Preferred examples of the organic solvent to be used as the dispersion medium include: nitrogen-containing polar solvents such as N,N,N',N'-tetramethylurea (TMU), N-methyl-2-pyrrolidone (NMP), N,N-dimethylacetamide (DMAc), N,N-dimethylisobutylamide, N,N-diethylacetamide, N,N-dimethylformamide (DMF), N,N-dimethylformamide, N,N-methylcaprolactam, 1,3-dimethyl-2-imidazolidinone (DMI), and pyridine; ketones such as diethyl ketone, methylbutyl ketone, dipropylketone, and cyclohexanone; alcohols such as n-pentanol, 4-methyl-2-pentanol, cyclohexanol, and diacetone alcohol; ether-based alcohols such as ethylene glycol monomethyl ether, ethylene glycol monoethyl ether, ethylene glycol monobutyl ether, propylene glycol monomethyl ether, propylene glycol monoethyl ether, diethylene glycol monomethyl ether, diethylene glycol monoethyl ether, diethylene glycol dimethyl ether, and diethylene glycol diethyl ether; saturated aliphatic monocarboxylate alkyl esters such as n-butyl acetate and amyl acetate; lactate esters such as ethyl lactate and n-butyl lactate; and ether-based esters such as methylcellosolve acetate, ethylcellosolve acetate, propylene glycol monomethyl ether acetate, propylene glycol monoethyl ether acetate, ethyl-3-ethoxypropionate, 2-methoxybutyl acetate, 3-methoxybutyl acetate, 4-methoxybutyl acetate, 2-methyl-3-methoxybutyl acetate, 3-methyl-3-methoxybutyl acetate, 3-ethyl-3-methoxybutyl acetate, 2-ethoxybutyl acetate, 4-ethoxybutyl acetate, 4-propoxybutyl acetate, and 2-methoxypentyl acetate, and the like. These may be used singly or in combination of two or more.

A solid content concentration of the radio wave absorbing layer forming paste is appropriately adjusted in accordance with a method of applying the radio wave absorbing layer forming paste, a thickness of the radio wave absorbing layer, or the like. Typically, the solid content concentration of the radio wave absorbing layer forming paste is preferably 3% by mass or more and 60% by mass or less and more preferably 10% by mass or more and 50% by mass or less. It should be noted that the solid content concentration of the paste is a value calculated by considering a total of a mass of a component not dissolved in the dispersion medium and a mass of a component dissolved in the dispersion medium as a solid content mass.

### <Substrate layer>

The above-mentioned radio wave absorbing layer is laminated on the substrate layer. The substrate layer may be a layer including any substrate without impairing the effect of the present invention, and examples thereof include layers including a resin. Examples of the above-mentioned resin include polyethylene terephthalate (PET), polyethylene naphthalate (PEN), acrylic (PMMA), polycarbonate (PC), a cycloolefin polymer (COP), polyether sulfone, polyimide, polyamide-imide, and the like. Among them, PET is preferable because of excellent heat resistance and well-balanced dimension stability and cost.

The substrate layer may have a curved surface or be only composed of a planar surface, and is preferably a flat plate shape. A thickness of the substrate layer is preferably 800 µm or less, more preferably 500 µm or less, further preferably 300 µm or less, and particularly preferably 150 µm or less from the viewpoint of thinning or downsizing of the film without impairing the effect of the present invention. The lower limit of the thickness of the substrate layers is not particularly limited without impairing the effect of the present invention, but, for example, 1 µm or more, 10 µm or more, 50 µm or more, or the like.

### <Metal layer>

A metal layer may be disposed on a surface of the substrate layer opposite to a surface on which the radio wave absorbing layer is disposed. When the metal layer is disposed, radio waves reflected by the metal layer can be attenuated. As metal constituting the metal layer, for example, aluminum, titanium, SUS, copper, brass, silver, gold, and platinum are preferred. A thickness of the metal layer is not particularly limited, but is preferably 600 µm or less, more preferably 400 µm or less, further preferably 100 µm or less, and particularly preferably 50µm or less from the viewpoint of thinning the radio wave absorber film. The lower limit of the thickness of the metal layer is not particularly limited without impairing the effect of the present invention, but is, for example, 0.1 µm or more, 1 µm or more, 5 µm or more, 10 µm or more, or the like.

### <Application>

The above-mentioned radio wave absorber film can be preferably used as a radio wave absorbing film to be used for a variety of elements (including automotive elements, high-frequency antenna elements, etc.) in various information communication systems such as cellular telephones, wireless LANs, ETC systems, intelligent transport systems, driving support road systems, satellite broadcasting, and the like

### <<Method for producing radio wave absorber film>>

A method for producing the above-mentioned radio wave absorber film is not particularly limited as long as a radio wave absorber film having a predetermined configuration can be produced. Preferably, the method for producing the radio wave absorber film includes a radio wave absorbing layer forming step in which the radio wave absorbing layer is formed by coating the substrate layer with paste including the magnetic substance and the binder resin to thereby form a coating film and then drying the coating film. As mentioned above, the binder resin includes the aromatic ester-urethane copolymer.

The paste to be used in the radio wave absorbing layer forming step may be the radio wave absorbing layer forming paste.

A method for applying the radio wave absorbing layer forming paste onto the substrate layer is not particularly limited as long as a radio wave absorbing layer having a desired thickness can be formed. Examples of the application method include a spray coating method, a dip coating method, a roll coating method, a curtain coating method, a spin coating method, a screen printing method, a doctor blade method, and an applicator method, and the like. An applied film formed by the above-mentioned method may be dried to remove a dispersion medium, thereby forming the radio wave absorbing layer. A thickness of the applied film is appropriately adjusted so that a thickness of the thus-dried radio wave absorbing layer is a desired thickness. A drying method is not particularly limited, and examples thereof include (1) a method of drying the film on a hot plate at a temperature of 80°C or more and 180°C or less and preferably 90°C or more and 160°C or less for 1 minute or more and 30 minutes or less, (2) a method of leaving to stand the film at room temperature for several hours to several days, (3) a method of placing the film in a warm air heater or an infrared heater for several tens of minutes to several hours, thereby removing a solvent, and the like.

The method for producing the radio wave absorber film may include a cutting step in which a laminate that includes the substrate layer and the radio wave absorbing layer and that obtained from the radio wave absorbing layer forming step is cut to thereby obtain a radio wave absorber film having a predetermined size. As mentioned above, the radio wave absorbing layer of the present invention has good crack resistance because the aromatic ester-urethane copolymer is included as the binder resin. Therefore, a crack is less likely to occur on a cut surface of the radio wave absorbing layer even though the radio wave absorber film is cut.

### EXAMPLES

Hereinafter, the present invention will be described in more detail based on Examples, but is not limited thereto.

### [Example 1]

### (Preparation of Radio Wave Absorbing Layer Forming Paste)

To 35 parts by mass of TMU, were added 40 parts by mass of the below-mentioned epsilon-type iron oxide, 2 parts by mass of the below-mentioned carbon nanotube (CNT), 3 parts by mass of the below-mentioned dispersant, and 20 parts by mass of the below-mentioned binder resin solution. The resultant was stirred by a rotating and revolving mixer to uniformly dissolve or disperse the above-mentioned components. Thus, a radio wave absorbing layer forming paste was obtained.

As the epsilon-type iron oxide, εc-Ga_{0.45}Fe_{1.55}O₃ was used. The epsilon-type iron oxide had an average particle size of 20 nm or more and 30 nm or less. As the CNT, a multilayered carbon nanotube having a major axis of 150 nm (commercial name: VGCF-H; manufactured by Showa Denko K.K.) was used. As the dispersant, phenyltrimethoxysilane was used. As the binder resin solution, an aromatic ester-urethane copolymer (manufactured by TOYOBO CO., LTD., VYLON UR-3210, glass transition temperature: -3°C, weight average molecular weight: 40000, composed of 5 parts by mass of a resin and 15 parts by mass of methyl ethyl ketone) was used.

### (Production of radio wave absorber film)

A PET film (thickness: 125 µm) was coated with the above-mentioned radio wave absorbing layer forming paste using an applicator. Then, the resultant coating film was dried at 90°C for 10 minutes and at 130°C for 10 minutes to thereby form a radio wave absorbing layer having a thickness of 35 µm. Thus, a radio wave absorber film was obtained. Immediately after the drying, the resultant radio wave absorber film was cut to a square of 5 cm x 5 cm. Thus, a test piece for the below-mentioned evaluation was produced.

### <Reflection loss>

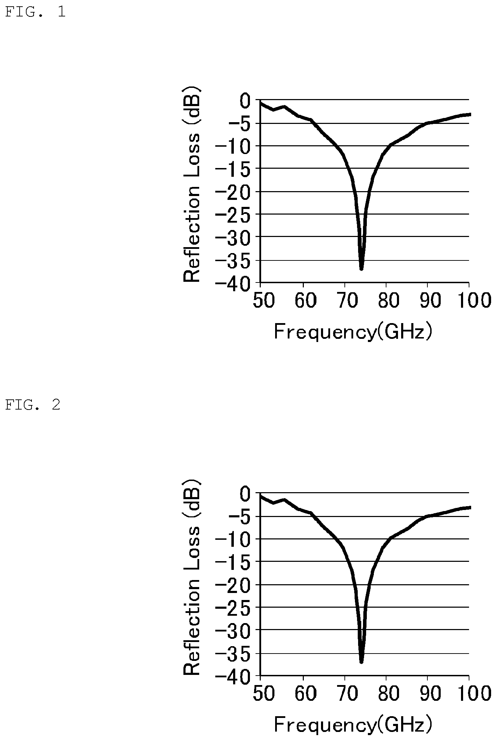

The sample of the radio wave absorber film cut to the square of 5 cm x 5 cm was adhered onto an aluminum plate. A radio wave of 50 to 100 GHz was allowed to be incident on the sample for measurement on the aluminum plate and reflection loss thereof was measured using Terahertz Spectroscopic System (manufactured by ADVANTEST CORPORATION). Reflection loss RL (f) at a frequency f was determined by RL (f) = -10 Log (R(f)/100) wherein R (f) is reflectance (%). Reflection loss (dB) of the radio wave absorber film of Example 1 in a frequency of 50 to 100 GHz is shown in FIG. 1.

### <Crack resistance (bending)>

The resultant sample of the radio wave absorber film was bent by 180 degrees and then verified whether a crack occurred on both surfaces of the film in the proximity of a crease. If no crack occurred, it was determined as good, and if a crack occurred, it was determined as poor.

### <Crack resistance (cutting)>

The resultant plurality of samples of the radio wave absorber film were cut using a cutter and then verified whether a crack occurred on both surfaces of each of the films in the proximity of a cut surface. If no crack occurred in all samples, it was determined as good, if a crack occurred in some of the plurality of the samples, it was determined as fair, and if a crack occurred in all samples, it was determined as poor.

### <Warping>

Immediately after the drying, the resultant sample of the radio wave absorber film was placed on a flat table and evaluated for warping by measuring an angle between the radio wave absorber film and a flat surface of the table. If the angle was less than 15 degrees, it was determined as good, and if the angle was 15 degrees or more, it was determined as poor.

### [Example 2]

The radio wave absorber film was produced and evaluated in the same manner as in Example 1, except that the binder resin was changed to an aromatic ester-urethane copolymer (manufactured by TOYOBO CO., LTD., VYLON UR-8300, glass transition temperature: 23°C, weight average molecular weight: 30000, composed of 5 parts by mass of a resin and 15 parts by mass of methyl ethyl ketone). Evaluation results are presented in Table 1. Reflection loss of the radio wave absorber film of Example 2 in a range of 50 to 100 GHz is shown in FIG. 2.

### [Example 3]

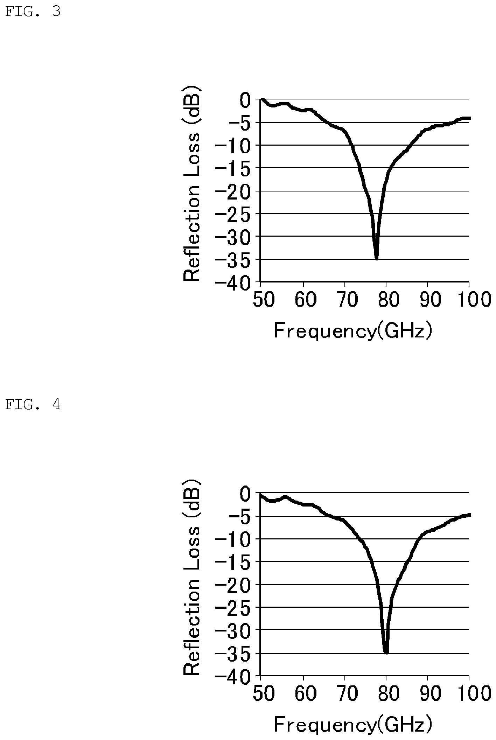

The radio wave absorber film was produced and evaluated in the same manner as in Example 1, except that the binder resin was changed to an aromatic ester-urethane copolymer (manufactured by TOYOBO CO., LTD., VYLON UR-1400, glass transition temperature: 83°C, weight average molecular weight: 40000, composed of 5 parts by mass of a resin and 15 parts by mass of methyl ethyl ketone). Evaluation results are presented in Table 1. Reflection loss of the radio wave absorber film of Example 3 in a range of 50 to 100 GHz is shown in FIG. 3.

### [Example 4]

The radio wave absorber film was produced and evaluated in the same manner as in Example 1, except that the binder resin was changed to an aromatic ester-urethane copolymer (manufactured by TOYOBO CO., LTD., VYLON UR-8700, glass transition temperature: -22°C, weight average molecular weight: 32000, composed of 5 parts by mass of a resin and 15 parts by mass of methyl ethyl ketone). Evaluation results are presented in Table 1. Reflection loss of the radio wave absorber film of Example 4 in a range of 50 to 100 GHz is shown in FIG. 4.

### [Comparative Example 1]

### (Preparation of Radio Wave Absorbing Layer Forming Paste)

To 50.9 parts by mass of TMU, were added 35.1 parts by mass of the above-mentioned epsilon-type iron oxide, 2.2 parts by mass of the above-mentioned carbon nanotube (CNT), 3.5 parts by mass of the below-mentioned dispersant, and 8.3 parts by mass of the below-mentioned binder resin. The resultant was stirred by a rotating and revolving mixer to uniformly dissolve or disperse the above-mentioned components. Thus, a radio wave absorbing layer forming paste was obtained.

As the binder resin solution, ethyl cellulose (manufactured by NISSIN KASEI CO., LTD.) was used.

### (Production of radio wave absorber film)

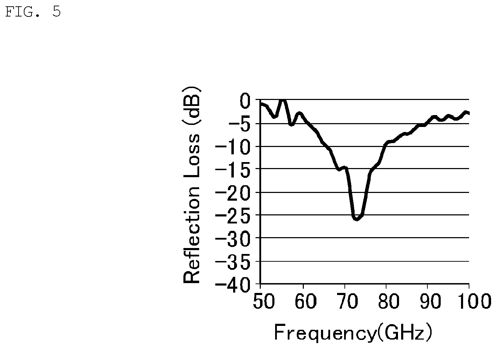

A PET film (thickness: 125 µm) was coated with the above-mentioned radio wave absorbing layer forming paste using an applicator. Then, the resultant coating film was dried at 90°C for 10 minutes and at 130°C for 10 minutes to thereby form a radio wave absorbing layer having a thickness of 35 µm. Thus, a radio wave absorber film was obtained. Immediately after the drying, the resultant radio wave absorber film was cut to a square of 5 cm x 5 cm. Thus, a test piece for evaluation was produced. Evaluation results are presented in Table 1. Reflection loss of the radio wave absorber film of Comparative Example 1 in a range of 50 to 100 GHz is shown in FIG. 5.

**[Table 1]**

| | | Example 1 | Example 2 | Example 3 | Example 4 | Comparative example 1 |
|---|---|---|---|---|---|---|
| Binder resin | Type | Aromatic ester-urethane copolymer | | | | Ethylcellulose |
| | Tg | -3°C | 23°C | 83°C | -22 °C | About 130 °C |
| | Mw | 40000 | 30000 | 40000 | 32000 | 77180 |
| Film thickness of radio wave absorbing layer | | 35µm | 35µm | 35µm | 35µm | 75µm |
| Maximum absorbed amount (50~100GHz) | | 36.8 dB | 35.8 dB | 34.9 dB | 35.1 dB | 25.6 dB |
| Crack resistance | Bending | Good | Poor | Poor | Good | Poor |
| | Cutting | Good | Good | Fair | Good | Poor |
| Warping | | Good | Good | Good | Good | Good |

Table 1 demonstrates that the radio wave absorber films of Examples each including the radio wave absorbing layer formed by using as the binder resin the aromatic ester-urethane copolymer absorbed a large amount of radio waves in a frequency of 50 to 100 GHz even though the radio wave absorbing layer were thin. On the other hand, it was demonstrated that the radio wave absorber film of Comparative Example including the radio wave absorbing layer formed by using as the binder resin the ethylcellulose absorbed a less amount of radio waves in a frequency of 50 to 100 GHz than that of the radio wave absorber films of Examples even though it had the radio wave absorbing layer thicker than that of Examples.

Furthermore, the crack was less likely to occur upon cutting in the radio wave absorber films of Examples each formed by using as the binder resin the aromatic ester-urethane copolymer. In particular, the crack was also less likely to occur upon bending by 180 degrees in the radio wave absorber films of Examples 1 and 4 each formed by using as the binder resin the aromatic ester-urethane copolymer having Tg of 0°C or less. On the other hand, the crack occurred upon both bending and cutting in the radio wave absorber film of Comparative Example including the radio wave absorbing layer formed by using as the binder resin the ethyl cellulose.

## Claims

1. A radio wave absorber film comprising:
a substrate layer; and
a radio wave absorbing layer formed on the substrate layer, the radio wave absorbing layer comprising a magnetic substance and a binder resin; and
the binder resin comprising an aromatic ester-urethane copolymer.

2. The radio wave absorber film according to claim 1, wherein the binder resin has a glass transition temperature of 100°C or less.

3. The radio wave absorber film according to claim 2, wherein the binder resin has a glass transition temperature of 0°C or less.

4. The radio wave absorber film according to any one of claims 1 to 3, wherein the magnetic substance comprises at least one selected from the group consisting of epsilon-type iron oxide, barium ferrite magnetic substance, and strontium ferrite magnetic substance.

5. The radio wave absorber film according to any one of claims 1 to 4, wherein the radio wave absorbing layer comprises a carbon nanotube.

6. The radio wave absorber film according to any one of claims 1 to 5, wherein the film has a thickness of 200 µm or less.

7. The radio wave absorber film according to claim 6, wherein the radio wave absorbing layer has a thickness of 50 µm or less.

8. A method for producing a radio wave absorber film comprising:
forming a radio wave absorbing layer by coating a substrate layer with paste comprising a magnetic substance and a binder resin to thereby form a coating film and then drying the coating film,
the binder resin comprising an aromatic ester-urethane copolymer.

9. The method for producing a radio wave absorber film according to claim 8, wherein the method comprises cutting a laminate that is obtained by forming the radio wave absorbing layer and that comprises the substrate layer and the radio wave absorbing layer to thereby obtain a radio wave absorber film having a predetermined size.
